# EUROPEAN PATENT APPLICATION

(11) **EP 4 524 584 A1**
(43) Date of publication of application: **19.03.2025**
(21) Application number: 23907488.3
(22) Date of filing: 30.11.2023
(51) Int. Cl.: G01R 31/327, G01R 19/25, G01R 19/00

(54) **BATTERY SYSTEM, RELAY REVERSE ELECTROMOTIVE FORCE PROTECTION CIRCUIT, AND PROTECTION CIRCUIT MONITORING METHOD**

(30) Priority: 23.12.2022 KR 20220183572
(71) Applicant: LG Energy Solution, Ltd., Seoul 07335 (KR)
(72) Inventor: LEE, Sang Rae, Daejeon 34122 (KR)
(74) Representative: Plasseraud IP
(86) International application number: PCT/KR2023/019515
(87) International publication number: WO 2024/136202

(57) **Abstract**

The present disclosure relates to a battery system, a relay back electromotive force (EMF) protection circuit, and a protection circuit monitoring method. The battery system includes a battery pack; a relay that is connected to one of both terminals of the battery pack and includes a relay coil; and a battery management system (BMS) that is connected to the relay coil to control an operation of the relay, in which the BMS includes: a protection circuit that applies a voltage to the relay coil to operate the relay and includes a capacitor connected in parallel with the relay coil, and a main control unit (MCU) that transmits a control signal for controlling an operation of the relay to the protection circuit and diagnoses an operation of the protection circuit based on a voltage signal received from the protection circuit.

## Description

### CROSS-REFERENCE TO RELATED APPLICATION

This application claims priority to and the benefit of Korean Patent Application No. 10-2022-0183572 filed in the Korean Intellectual Property Office on December 23, 2022, the entire contents of which are incorporated herein by reference.

### [Technical Field]

The present disclosure relates to a battery system, a relay back electromotive force (EMF) protection circuit, and a protection circuit monitoring method.

### [Background Art]

A mechanical relay may include a coil and a contactor. When power applied to the coil is turned off to stop an operation of a relay, back electromotive force (EMF) is generated in the coil. The back EMF is a phenomenon that occurs due to current characteristics of the relay coil.

When the back EMF is excessively generated, a failure may occur in a relay driver that drives the relay.

### [Summary]

### [Technical Problem]

The present disclosure attempts to provide a battery system capable of preventing back electromotive force (EMF) by including a protection circuit that prevents the back EMF generated in a relay and diagnosing whether the protection circuit is operating normally, a relay back EMF protection circuit, and a protection circuit monitoring method.

### [Technical Solution]

According to an aspect of the present disclosure, a battery system includes: a battery pack; a relay that is connected to one of both terminals of the battery pack and includes a relay coil; and a battery management system (BMS) that is connected to the relay coil to control an operation of the relay, in which the BMS includes a protection circuit that applies a voltage to the relay coil to operate the relay and includes a capacitor connected in parallel with the relay coil, and a main control unit (MCU) that transmits a control signal for controlling the operation of the relay to the protection circuit and diagnoses an operation of the protection circuit based on a voltage signal received from the protection circuit.

The protection circuit may include: a first switch that applies a driving voltage to a high side of the relay coil; a second switch that connects ground to a low side of the relay coil; and a Schottky diode that is connected in parallel with the relay coil and has a cathode terminal connected to the high side of the relay coil and an anode terminal connected to the low side of the relay coil.

The BMS may further include: a first ADC that generates a first voltage measurement signal by analog-to-digital converting a signal corresponding to a high side voltage of the relay coil; and a second ADC that generates a second voltage measurement signal by analog-to-digital converting a signal corresponding to a low side voltage of the relay coil.

The MCU may determine whether the protection circuit is in a normal state based on the first voltage measurement signal and the second voltage measurement signal.

The MCU may monitor the first voltage measurement signal and the second voltage measurement signal to derive a first voltage value representing the voltage across the relay coil in an on state of the first switch and the second switch, derives a second voltage value representing the voltage across the relay coil in an off state of the first switch or the second switch, measure back EMF of the relay coil based on the first voltage value and the second voltage value, and determine whether the protection circuit is in a normal state based on the back EMF.

According to another aspect of the present disclosure, a relay back EMF protection circuit includes: a first switch that applies a driving voltage to a high side of a relay coil included in the relay; a second switch that connects ground to a low side of the relay coil; a capacitor that is connected in parallel with the relay coil; and a Schottky diode that has a cathode terminal connected to the high side of the relay coil, and an anode terminal connected to the low side of the relay coil.

The protection circuit may further include: a first resistor and a second resistor that are connected in series to the high side of the relay coil; a diode that has the anode terminal to which a voltage is applied and the cathode terminal connected to one terminal of a third resistor, the other terminal of the third resistor being connected to the low side of the relay coil; and a fourth resistor and a fifth resistor that are connected in series to the low side of the relay coil, and a signal representing a voltage corresponding to a high side voltage of the relay coil is output from a node between a first resistor and the second resistor, and a signal representing a voltage corresponding to a low side voltage of the relay coil is output from a node between a fourth resistor and the fifth resistor.

According to still another aspect of the present disclosure, a protection circuit monitoring method for preventing back EMF of a relay includes: turning on, by a main control unit (MCU), a high side switch connected to a high side of a relay coil included in the relay and a low side switch connected to a low side of the relay coil; receiving, by the MCU, two first signals from the protection circuit; deriving, by the MCU, a first voltage value representing a voltage across the relay coil in an on state of the high side switch and the low side switch based on the two first signals; turning off, by the MCU, the high side switch or the low side switch; receiving, by the MCU, two second signals from the protection circuit; deriving, by the MCU, a second voltage value representing the voltage across the relay coil in an off state of the high side switch and the low side switch based on the second signals; and diagnosing, by the MCU, an operation of the protection circuit based on the first voltage value and the second voltage value.

The protection circuit may include: a capacitor that is connected in parallel with the relay coil; and a Schottky diode that is connected in parallel with the relay coil and has a cathode terminal connected to a high side of the relay coil and an anode terminal connected to a low side of the relay coil.

The diagnosing of, by the MCU, the operation of the protection circuit based on the first voltage value and the second voltage value may include: measuring the back EMF of the relay coil based on the first voltage value and the second voltage value and determining whether the protection circuit is in a normal state based on the back EMF.

### [Advantageous Effects]

According to the present disclosure, it is possible to reduce back electromotive force (EMF) generated in a relay coil and quickly discharge the back EMF.

According to the present disclosure, it is possible to reduce the back EMF to protect a driver driving the relay coil from being destroyed by excessive back EMF.

According to the present disclosure, it is possible to determine whether the protection circuit operates normally by monitoring a voltage across the relay coil from the protection circuit for preventing back EMF.

### [Brief Description of the Drawings]

FIG. 1 is a block diagram schematically illustrating a battery system according to an embodiment.
FIG. 2 is a circuit diagram of a protection circuit of FIG. 1.
FIG. 3 is a circuit diagram of the protection circuit of FIG. 1 with a switch turned off.
FIG. 4 is a flowchart of a protection circuit monitoring method according to an embodiment.
FIG. 5 is an exemplary diagram of a comparison circuit including a TVS diode and a Schottky diode.
FIG. 6 is a diagram illustrating a high side voltage graph of a relay coil connected to the comparison circuit of FIG. 5.
FIG. 7 is a high side voltage graph of the relay coil according to an embodiment.
FIG. 8 is a low side voltage graph of the relay coil connected to the comparison circuit of FIG. 5.
FIG. 9 is a low side voltage graph of the relay coil according to an embodiment.

### [Detailed Description]

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. Further, when it is decided that a detailed description for the known art related to the present disclosure may obscure the gist of the present disclosure, the detailed description will be omitted. Further, it should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

Among the components according to an embodiment, a program implemented as a set of instructions specifying a control algorithm necessary for controlling other components may be installed in a component that controls other components under specific control conditions. The control component may process input data and stored data according to installed programs to generate output data. The control component may include non-volatile memory for storing programs and memory for storing data.

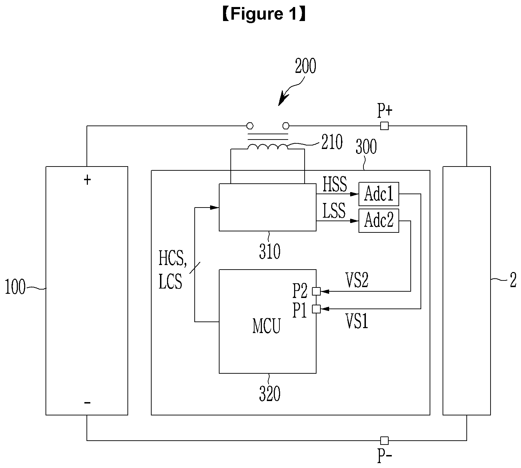

FIG. 1 is a block diagram schematically illustrating a battery system according to an embodiment.

Referring to FIG. 1, a battery system 1 may include a battery pack 100, a relay 200, and a battery management system (BMS) 300.

The battery pack 100 may include a plurality of battery cells. The battery pack 100 may be implemented as two or more battery cells connected in series, a plurality of battery cells having two or more battery cells connected in parallel, or two or more battery cells connected in parallel.

The relay 200 may include a relay coil 210. One terminal of the relay 200 may be connected to one of both terminals of the battery pack 100. The other terminal of the relay 200 may be connected to an external device 2.

The battery system 1 may be connected to the external device 2. The external device 2 may include a load and a charging device such as an inverter or a converter. When the external device 2 is a charger, both terminals P+ and P- of the battery system 1 may connected to the charger and charged by receiving power from the charger. When the external device 2 is a load, both the terminals P+ and P- of the battery system 1 are connected to the load so that the power supplied by the battery pack 100 may be discharged through the load.

In FIG. 1, the relay 200 is illustrated as being included only between a positive terminal + of the battery pack 100 and the terminal P+ of the battery system 1, but the present disclosure is not limited thereto. The battery system 1 may also include a relay between a negative terminal - of the battery pack 100 and the terminal P- of the battery system 1, and a relay back electromotive force protection circuit, which will be described later, may be equally applied to the relay between the negative terminal - and the terminal P- of the battery system 1.

The BMS 300 may operate the relay coil 210 and determine whether the protection circuit that reduces back electromotive force (EMF) of the relay coil 210 operates within a normal range. The BMS 300 may include a relay back EMP protection circuit (hereinafter, "protection circuit") 310, a main control unit (MCU), and analog-to-digital converters (ADC) ADC1 and ADC2.

The protection circuit 310 may be a circuit that discharges the back EMF that may occur due to characteristics of the relay coil 210. The protection circuit 310 may operate based on a high side control signal HCS and a low side control signal LSC that are received from a MCU 320. The protection circuit 310 may operate the relay 200 by applying a voltage to the relay coil 210 using the high side control signal HCS and the low side control signal (LSC). When the voltage applied to the relay coil 210 disappears due to a switching operation, a reverse voltage may be applied to both the terminals of the relay coil 210. The protection circuit 310 may reduce the reverse voltage generated at both the terminals of the relay coil 210. In addition, the protection circuit 310 may provide a discharge path so that the back EMF is quickly discharged. The protection circuit 310 may generate a high side signal HSS corresponding to a voltage on a high side of the relay coil 210 and transmit the generated high side signal to the first analog-to-digital converter ADC1, and generate a low side signal LSS corresponding to a voltage on a low side of the relay coil 210 and transmit the generated low side signal LSS to the second analog-to-digital converter ADC2.

The first analog-to-digital converter ADC1 may generate a voltage measurement signal VS1 obtained by analog-to-digital converting the high side signal HSS and transmit the generated voltage measurement signal VS1 to the MCU 320. The second analog-to-digital converter ADC2 may generate a voltage measurement signal VS2 obtained by analog-to-digital converting the low side signal LSS and transmit the generated voltage measurement signal VS2 to the MCU 320.

The MCU 320 may include a terminal P1 and a terminal P2. The MCU 320 may receive the voltage measurement signal VS1 from the first analog-to-digital converter ADC1 through the terminal P1. The MCU 320 may receive the voltage measurement signal VS2 from the second analog-to-digital converter ADC2 through the terminal P2. The MCU 320 may derive a high side voltage value V_COIL_H of the relay coil 210 based on the voltage measurement signal VS1. The MCU 320 may derive a low side voltage value V_COIL_L of the relay coil 210 based on the voltage measurement signal VS2.

When excessive back EMF is generated, it may exceed a limit of a relay driver driving the relay 200, which may lead to destruction of the driver. Therefore, the protection circuit 310 may operate as a back EMF absorber to prevent the driver destruction.

The MCU 320 may control the driving of the protection circuit 310 by generating the high side control signal HCS and the low side control signal LSC and transmitting the high side control signal HCS and low side control signal LSC to the protection circuit 310. The MCU 320 may monitor the voltage across the relay coil 210 based on the voltage measurement signal VS1 and the voltage measurement signal VS2, and determine whether the protection circuit 310 operates in the normal range based on the monitoring results. The voltage measurement signal VS1 may represent a value corresponding to the voltage on the high side (one terminal) of the relay coil 210, and the voltage measurement signal VS2 may represent a value corresponding to the voltage on the low side (other terminal) of the relay coil 210.

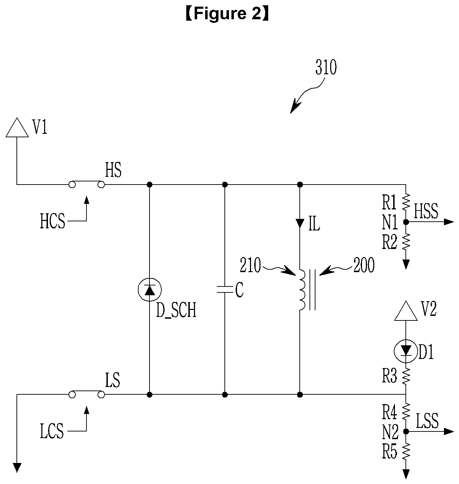

Hereinafter, the operation of the protection circuit 310 will be reviewed with reference to FIG. 2.

FIG. 2 is a circuit diagram of the protection circuit of FIG. 1.

Referring to FIG. 2, the protection circuit 310 may include a high side switch HS, a low side switch LS, a Schottky diode D_SCH, a capacitor C, the relay coil 210, and a plurality of resistors R1-R5, and a diode D1. The Schottky diode D_SCH, the capacitor C, and the relay coil 210 may be connected in parallel.

The high side control signal HCS may control the high side switch HS to be opened and closed. The low side control signal LCS may control the low side switch LS to be opened and closed. The high side switch HS may be a switch inside a high side driver connected to the high side of the relay coil 210. The low side switch LS may be a switch inside a low side driver connected to the low side of the relay coil 210.

FIG. 2 illustrates that the high side control signal HCS and low side control signal LCS generated by the MCU 320 control the high side switch HS and the low side switch LS to be opened and closed, but the present disclosure is not limited thereto. The high side control signal HCS and the low side control signal LCS are transmitted to the corresponding driver among a high side driver HSD and a low side driver LSD, respectively, and the HSD and LSD may control the high side switch HS and the low side switch LS.

The high side switch HS may be connected to the high side of the relay coil 210 to apply a driving voltage V1 to the relay coil 210. The voltage V1 may be applied to one terminal of the high side switch HS. For example, the voltage V1 may be a 12V voltage supplied from an auxiliary terminal AUX of a vehicle. A cathode terminal of the Schottky diode D_SCH, one terminal of the capacitor C, one terminal of the relay coil 210, and one terminal of the resistor R1 may be connected to the other terminal of the high side switch HS. One terminal of the resistor R2 may be connected to the other terminal of the resistor R1. The other terminal of the resistor R2 may be connected to ground.

The high side signal HSS may represent a node N1 voltage between the resistor R1 and the resistor R2. The voltage represented by the high side signal HSS may be a voltage corresponding to the voltage at one terminal (high side) of the relay coil 210.

The low side switch LS may be connected to the low side of the relay coil 210 to connect the relay coil 210 to the ground. One terminal of the low side switch LS may be connected to the ground. An anode terminal of the Schottky diode D_SCH, the other terminal of the capacitor C, the other terminal of the relay coil 210, one terminal of the resistor R3, and one terminal of the resistor R4 may be connected to the other terminal of the low side switch LS. A voltage V2 may be applied to an anode terminal of the diode D1. A cathode terminal of the diode D1 may be connected to the other terminal of the resistor R3. One terminal of the resistor R5 may be connected to the other terminal of the resistor R4. The other terminal of the resistor R5 may be connected to the ground.

The low side signal LSS may represent a node N2 voltage between the resistor R4 and the resistor R5. The voltage represented by the low side signal LSS may be a voltage corresponding to the voltage at the other terminal (low side) of the relay coil 210.

The MCU 320 may monitor the voltage measurement signal VS1 and the voltage measurement signal VS2 received from the first analog-to-digital converter ADC1 and the second analog-to-digital converter ADC2. The MCU 320 may control the operations of the high side switch HS and the low side switch LS through the high side control signal HCS and low side control signal LCS during the monitoring.

The MCU 320 may monitor the voltage measurement signal VS1 and the voltage measurement signal VS2 to derive a first voltage value representing the voltage across the relay coil 210 when the high side switch HS and the low side switch LS are in an on state. In addition, the MCU 320 may monitor the voltage measurement signal VS1 and the voltage measurement signal VS2 to derive a second voltage value representing the voltage across the relay coil 210 when the high side switch HS and the low side switch LS are in an off state. The MCU 320 may measure the back EMF of the relay coil 210 based on the first voltage value and the second voltage value.

When the MCU 320 may generate an on-level high side control signal HCS and an on-level low side control signal LCS and transmits the on-level high side control signal HCS and on-level low side control signal LCS to the protection circuit 310, the high side switch HS and the low side switch LS may be closed. When the high side switch HS and the low side switch LS are closed, the voltage V1 is applied to the relay coil 210 so that a coil current IL may flow. The relay 200 may be turned on by a magnetic field caused by the coil current IL. While the high side switch HS and the low side switch LS are closed, the capacitor C may store charge according to the voltage across the relay coil 210. In the on state of the high side switch HS and the low side switch LS, the voltage measurement signal VS1 may be divided from the voltage V1 by the resistor R1 and the resistor R2 to represent a voltage applied to one terminal of the resistor R2. When the high side switch HS and the low side switch LS are in the on state, the voltage measurement signal VS2 may represent the ground.

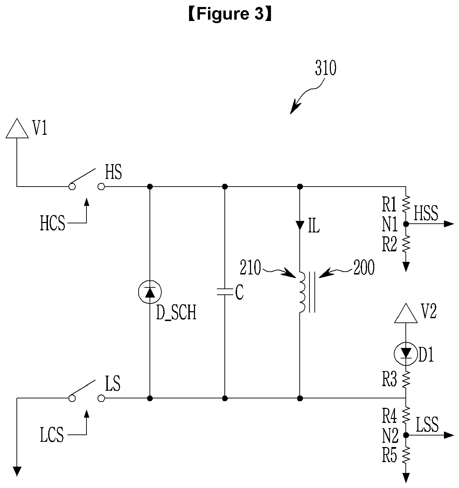

FIG. 3 is a circuit diagram of the protection circuit of FIG. 1 with the switch turned off.

Referring to FIG. 3, when the MCU 320 may generate an off-level high side control signal HCS and low side control signal LCS and transmits the off-level high side control signal HCS and low side control signal LCS to the protection circuit 310, the high side switch HS and the low side switch LS may be opened. When the high side switch HS and the low side switch LS perform a switching operation from the on state to the off state, a reverse voltage may be applied to both terminals of the relay coil 210. In this case, the voltage measurement signal VS1 changes from a voltage with a positive polarity to a voltage having a negative polarity according to the switching operation. When the high side switch HS and the low side switch LS are turned off, the voltage measurement signal VS2 may be divided from the voltage V2 by the resistor R3, the resistor R4, and the resistor R5, and may represent a voltage applied to one terminal of the resistor R5.

Hereinafter, the description will be made assuming that the voltage V1 and the voltage V2 are a voltage with a positive polarity.

When the high side switch HS and the low side switch LS are in the on state, the voltage measurement signal VS1 represents a higher voltage than the voltage measurement signal VS2, so the high side voltage of the relay coil 210 has a positive polarity, and the low side voltage has a negative polarity.

When the high side switch HS and the low side switch LS are turned off, the voltage measurement signal VS1 represents a lower voltage than the voltage measurement signal VS2, so the high side voltage of the relay coil 210 has a negative polarity, and the low side voltage has a positive polarity.

The moment the high side switch HS and the low side switch LS are opened, the voltage V1 is not applied to the relay coil 210, so the reverse voltage is generated on both terminals of the relay coil 210. The capacitor C is connected in parallel to the relay coil 210 to reduce the reverse voltage (v=-L*di/dt) generated across the relay coil. A time variation rate dt may increase by the capacitor C. The time variation rate refers to the time from the time when the voltage is blocked in the relay coil 210 to the time when the coil current stops flowing, and the period during which the coil current flows due to the voltage charged in the capacitor C is longer than when the capacitor C is not present, so the time variation rate may increase. Then, the reverse voltage generated across the relay coil 210 may decrease. In addition, the back EMF may be quickly discharged by connecting the Schottky diode D_SCH in parallel to the relay coil 210. The Schottky diode D_SCH forms a discharge path for discharging the back EMF generated in the relay coil 210, allowing the back EMF to be discharged quickly.

In an embodiment, the capacitor C and the Schottky diode D_SCH in the protection circuit 310 may be connected in parallel to the relay coil 210 to prevent excessive back EMF from being generated in the relay coil. When the excessive back EMF is generated, the high side switch HS and/or the low side switch LS may be destroyed. Accordingly, the protection circuit is provided to prevent the high side switch HS and/or the low side switch LS from being destroyed.

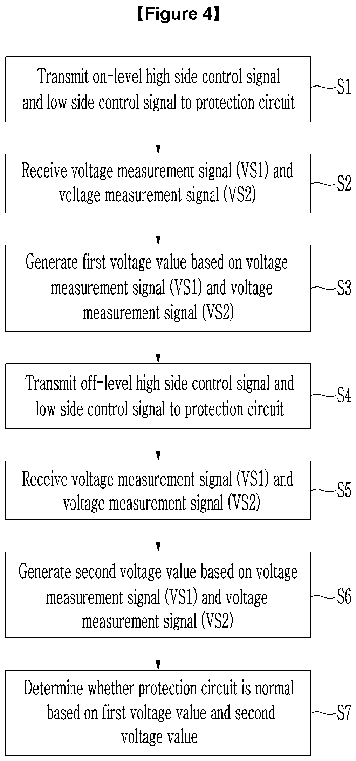

Hereinafter, a protection circuit monitoring method using the battery system 1 according to an embodiment will be described with reference to FIG. 4.

FIG. 4 is a flowchart of a protection circuit monitoring method according to an embodiment.

The MCU 320 may generate the on-level high side control signal HCS and low side control signal LCS and transmit the on-level high side control signal HCS and low side control signal LCS to the protection circuit 310 (S1). The high side switch HS and the low side switch LS that receive the on-level high side control signal HCS and low side control signal LCS may be turned on.

When the high side switch HS and the low side switch LS are closed, the MCU 320 may receive the voltage measurement signal VS1 and the voltage measurement signal VS2 from the first analog-to-digital converter ADC1 and the second analog-to-digital converter ADC2 (S2).

The MCU 320 may derive the first voltage value based on the voltage measurement signal VS1 and the voltage measurement signal VS2 (S3). A first voltage value may represent the voltage across the relay coil 210 when the high side switch HS and the low side switch LS are in the on state. The MCU 320 may derive the high side voltage value V_COIL_H and the low side voltage value V_COIL_L based on the voltage measurement signal VS1 and the voltage measurement signal VS2, and calculate the first voltage value based on the high side voltage value V_COIL_H and the low side voltage value V_COIL_L.

The MCU 320 may generate the off-level high side control signal HCS and low side control signal LCS and transmit the off-level high side control signal HCS and low side control signal LCS to the protection circuit 310 (S4).

When the high side switch HS and the low side switch LS are opened, the MCU 320 may receive the voltage measurement signal VS1 and the voltage measurement signal VS2 from the first analog-to-digital converter ADC1 and the second analog-to-digital converter ADC2.

The MCU 320 may derive the second voltage value based on the voltage measurement signal VS1 and the voltage measurement signal VS2 (S6). The second voltage value may represent the voltage across the relay coil 210 when the high side switch HS and the low side switch LS are in the off state. The MCU 320 may derive the high side voltage value V_COIL_H and the low side voltage value V_COIL_L based on the voltage measurement signal VS1 and the voltage measurement signal VS2, and calculate the second voltage value based on the high side voltage value V_COIL_H and the low side voltage value V_COIL_L.

The MCU 320 may determine whether the protection circuit 310 is in the normal state based on the first voltage value and the second voltage value (S7). The MCU 320 may monitor the first voltage value and the second voltage value to measure the back EMF of relay coil 210 at the time when the high side switch HS and the low side switch LS are switched from the on state to the off state. When a magnitude of the back EMF is less than or equal to a predetermined threshold level, the MCU 320 may determine that the protection circuit 310 is in the normal state.

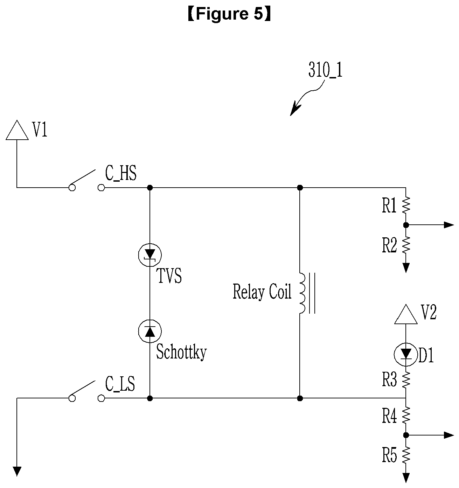

Hereinafter, the operation of an embodiment will be described with reference to Comparative Example of FIG. 5.

FIG. 5 is an exemplary diagram of a comparison circuit including a TVS diode and a Schottky diode.

A comparison circuit 310_1 illustrated in FIG. 5 is an example of the protection circuit for the relay coil, in which the Schottky diode and the TVS diode are connected in series, and does not include a capacitor. In the protection circuit 310_1, the switch connected to the high side of the relay coil is called a high side switch C_HS, and the switch connected to the low side of the relay coil is called a low side switch C_LS. In the protection circuit 310_1, the high side voltage of the relay coil is referred to as a high side voltage V_COMP_H, and the low side voltage of the relay coil is referred to as a low side voltage V_COMP_L.

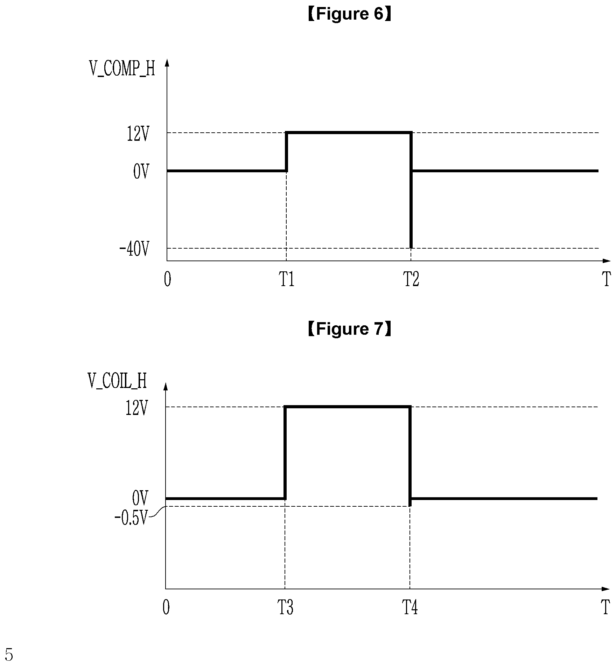

Hereinafter, referring to FIGS. 6 and 7, when the high side switch and the low side switch are closed and then the high side switch is opened, the high side voltage V_COMP_H of the relay coil connected to the comparison circuit 310_1 of FIG. 5 and the change in the high side voltage V_COIL_H of the relay coil 210 according to the protection circuit 310 according to an embodiment will be described.

FIG. 6 illustrates the high side voltage graph of the relay coil connected to the comparison circuit of FIG. 5.

In FIG. 6, from time T from 0 to T1, the high side switch C_HS is opened and the low side switch C_LS is closed. During the period of time T from 0 to T1, the high side voltage V_COMP_H of the relay coil connected to the comparison circuit 310_1 may represent 0V.

When the high side switch C_HS is closed at time T1, the voltage V_COMP_H may represent 12V. Since the high side switch C_HS and low side switch C_LS are closed from time T1 to time T2, the voltage V_COMP_H may represent 12V.

When the high side switch C_HS is opened at time T2, the back EMF may be generated in the relay coil, so the voltage V_COMP_H drops to -40V, and then may represent 0V after time T2.

FIG. 7 is a diagram illustrating a high side voltage graph of the relay coil according to an embodiment.

In FIG. 7, during the period of time T from 0 to T3, the high side switch HS is opened and the low side switch C_LS is closed. During the period from time T from 0 to T3, the high side voltage value V_COIL_H of the relay coil 210 according to an embodiment may represent 0V.

When the high side switch HS is closed at time T3, the voltage value V_COIL_H may represent 12V. Since the high side switch HS and low side switch LS are closed from time T3 to time T4, the voltage V_COIL_H may represent 12V.

When the high side switch HS is opened at time T4, the back EMF may be generated in the relay coil, so the voltage value V_COIL_H drops to -0.5V, and then may represent 0V after time T4.

Referring to FIGS. 6 and 7, when the high side switch is turned off, the high side voltage V_COMP_H of the relay coil to which the comparison circuit 310_1 is connected drops to -40V, but the high side voltage V_COIL_H of the relay coil 210 to which the protection circuit 310 according to the embodiment is connected is reduced only to -0.5V. This may be explained by assuming that when the low side switch LS is closed, the low side voltages V_COMP_L and V_COIL_L are 0V. In the comparison circuit 310_1, the voltage across the relay coil is -40-0=-40(V), but the voltage across the relay coil 210 according to the embodiment is -0.5-0=-0.5(V). Therefore, in an embodiment, since the reverse voltage is less than that of the comparison circuit 310_1, less back EMF may be generated due to the reverse voltage.

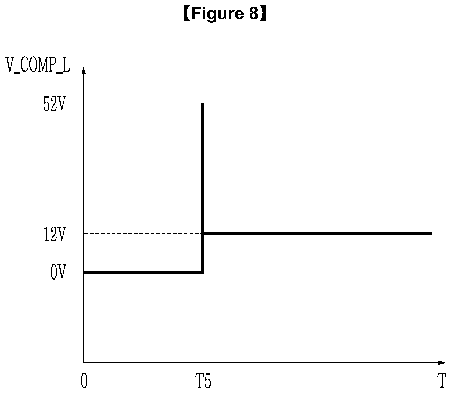

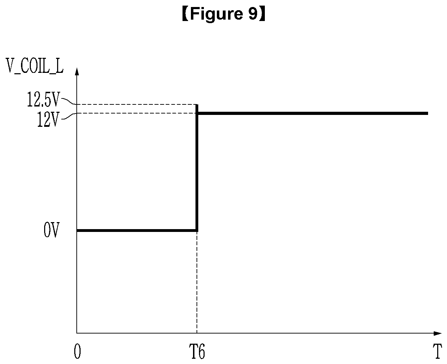

Hereinafter, referring to FIGS. 8 and 9, when the high side switch and the low side switch are closed and then the low side switch is opened, the low side voltage V_COMP_L of the relay coil connected to the comparison circuit 310_1 of FIG. 5 and the change in the low side voltage V_COIL_L of the relay coil 210 according to the protection circuit 310 according to an embodiment will be described.

FIG. 8 is the low side voltage graph of the relay coil connected to the comparison circuit of FIG. 5.

In FIG. 8, during the period of time T from 0 to T5, the high side switch C_HS and the low side switch C_LS are closed. During the period from time T from 0 to T5, the low side voltage V_COMP_L of the relay coil connected to the comparison circuit 310_1 may represent 0V.

When the low side switch C_LS is opened at time T5, the back EMF may be generated in the relay coil, so the voltage V_COMP_L rises to 52V, and then may represent 12V after time T5.

FIG. 9 is a diagram illustrating the low side voltage graph of the relay coil according to an embodiment.

In FIG. 9, during the period of time T from 0 to T6, the high side switch HS and the low side switch LS are closed. During the period from time T from 0 to T6, the low side voltage V_COIL_L of the relay coil 210 according to an embodiment may represent 0V.

When the low side switch C_LS is opened at time T6, the back EMF may be generated in the relay coil 210, so the voltage V_COMP_L rises to 12.5V, and then may represent 12V after time T6.

Referring to FIGS. 8 and 9, when the low side switch is turned off, the low side voltage V_COMP_L of the relay coil to which the comparison circuit 310_1 is connected rises to 52V, but the low side voltage V_COIL_L of the relay coil 210 to which the protection circuit 310 according to the embodiment is connected rises only to 12.5V. This may be explained by assuming that when the high side switch HS is closed, the high side voltages V_COMP_H and V_COIL_H are 12V. In the comparison circuit 310_1, the voltage across the relay coil is 12-52=-40(V), but the voltage across the relay coil 210 according to the embodiment is 12-12.5=-0.5(V). Therefore, in an embodiment, since the reverse voltage is less than that of the comparison circuit 310_1, less back EMF may be generated due to the reverse voltage.

In this way, the protection circuit 310 greatly reduces the back EMF generated in the relay coil 210, thereby enabling sufficient protection for the high side switch HS and/or the low side switch LS.

Although the embodiments of the present disclosure have been described in detail above, the scope of the present disclosure is not limited thereto, and various modifications and improvements by those of ordinary skill in the field to which the present disclosure pertains belong to the scope of the present disclosure.

## Claims

1. A battery system, comprising:
a battery pack;
a relay that is connected to one of both terminals of the battery pack and includes a relay coil; and
a battery management system (BMS) that is connected to the relay coil to control an operation of the relay,
wherein the BMS includes:
a protection circuit that applies a voltage to the relay coil to operate the relay and includes a capacitor connected in parallel with the relay coil, and
a main control unit (MCU) that transmits a control signal for controlling the operation of the relay to the protection circuit and diagnoses an operation of the protection circuit based on a voltage signal received from the protection circuit.

2. The battery system of claim 1, wherein:
the protection circuit includes:
a first switch that applies a driving voltage to a high side of the relay coil;
a second switch that connects ground to a low side of the relay coil; and
a Schottky diode that is connected in parallel with the relay coil and has a cathode terminal connected to the high side of the relay coil and an anode terminal connected to the low side of the relay coil.

3. The battery system of claim 2, wherein:
the BMS further includes:
a first ADC that generates a first voltage measurement signal by analog-to-digital converting a signal corresponding to a high side voltage of the relay coil; and
a second ADC that generates a second voltage measurement signal by analog-to-digital converting a signal corresponding to a low side voltage of the relay coil.

4. The battery system of claim 3, wherein:
the MCU determines whether the protection circuit is in a normal state based on the first voltage measurement signal and the second voltage measurement signal.

5. The battery system of claim 4, wherein:
the MCU monitors the first voltage measurement signal and the second voltage measurement signal to derive a first voltage value representing the voltage across the relay coil in an on state of the first switch and the second switch, derives a second voltage value representing the voltage across the relay coil in an off state of the first switch or the second switch, measures back electromotive force (EMF) of the relay coil based on the first voltage value and the second voltage value, and determines whether the protection circuit is in the normal state based on the back EMF.

6. A relay back EMF protection circuit, comprising:
a first switch that applies a driving voltage to a high side of a relay coil included in the relay;
a second switch that connects ground to a low side of the relay coil;
a capacitor that is connected in parallel with the relay coil; and
a Schottky diode that has a cathode terminal connected to the high side of the relay coil, and an anode terminal connected to the low side of the relay coil.

7. The protection circuit of claim 6, further comprising:
a first resistor and a second resistor that are connected in series to the high side of the relay coil;
a diode that has the anode terminal to which a voltage is applied and the cathode terminal connected to one terminal of a third resistor, the other terminal of the third resistor being connected to the low side of the relay coil; and
a fourth resistor and a fifth resistor that are connected in series to the low side of the relay coil, and
a signal representing a voltage corresponding to a high side voltage of the relay coil is output from a node between a first resistor and the second resistor, and a signal representing a voltage corresponding to a low side voltage of the relay coil is output from a node between a fourth resistor and the fifth resistor.

8. A protection circuit monitoring method for preventing back EMF of a relay, comprising:
turning on, by a main control unit (MCU), a high side switch connected to a high side of a relay coil included in the relay and a low side switch connected to a low side of the relay coil;
receiving, by the MCU, two first signals from the protection circuit;
deriving, by the MCU, a first voltage value representing a voltage across the relay coil in an on state of the high side switch and the low side switch based on the two first signals;
turning off, by the MCU, the high side switch or the low side switch;
receiving, by the MCU, two second signals from the protection circuit;
deriving, by the MCU, a second voltage value representing the voltage across the relay coil in an off state of the high side switch and the low side switch based on the second signals; and
diagnosing, by the MCU, an operation of the protection circuit based on the first voltage value and the second voltage value.

9. The method of claim 8, wherein:
the protection circuit includes:
a capacitor that is connected in parallel with the relay coil; and
a Schottky diode that is connected in parallel with the relay coil and has a cathode terminal connected to the high side of the relay coil and an anode terminal connected to the low side of the relay coil.

10. The method of claim 8, wherein:
the diagnosing of, by the MCU, the operation of the protection circuit based on the first voltage value and the second voltage value includes:
measuring the back EMF of the relay coil based on the first voltage value and the second voltage value and determining whether the protection circuit is in a normal state based on the back EMF.
